Europäisches Patentamt

**European Patent Office**

**Office européen des brevets**

(11) Numéro de publication: **0 062 590**
A1

(12) **DEMANDE DE BREVET EUROPEEN**

(21) Numéro de dépôt: **82400630.8**

(22) Date de dépôt: **06.04.82**

(51) Int. Cl.³: **H 03 J 3/14**

(30) Priorité: **08.04.81 FR 8107040**

(71) Demandeur: **THOMSON-BRANDT, 173, Boulevard Haussmann, F-75360 Paris Cedex 08 (FR)**

(43) Date de publication de la demande: **13.10.82 Bulletin 82/41**

(72) Inventeur: **Bouchant, Jean-Charles, THOMOSN-CSF SCPI 173, bld Haussmann, F-75360 Paris Cedex 08 (FR)**
Inventeur: **Dubuisson, Jacky, THOMSON-CSF SCPI 173, bld Haussmann, F-75360 Paris Cedex 08 (FR)**

(84) Etats contractants désignés: **DE GB IT NL**

(74) Mandataire: **Grynwald, Albert et al, THOMSON-CSF SCPI 173, Bld Haussmann, F-75360 Paris Cedex 08 (FR)**

(54) Récepteur radiophonique à indicateur de réception d'une émission.

㊐ Récepteur radiophonique comportant un démodulateur FM.
La sortie (11) de silencieux est reliée à un indicateur lumineux (18) qui forme un indicateur de réception ou d'accord.
Cette sortie (11) est également reliée, de façon classique, à des circuits permettant d'éliminer le souffle lors de la recherche d'une station.

EP 0 062 590 A1

1

## RECEPTEUR RADIOPHONIQUE A INDICATEUR DE RECEPTION D'UNE EMISSION.

L'invention est relative à un récepteur radiophonique à indicateur de réception d'une émission.

On connait de nombreux indicateurs permettant d'ajuster la fréquence d'accord d'un récepteur radiophonique pour qu'une émission soit reçue dans les meilleures conditions. Ils comprennent en général un indicateur visuel associé à des circuits électroniques souvent complexes. Ils ne sont donc utilisés que pour des récepteurs d'un prix relativement élevé.

Le récepteur selon l'invention comporte un indicateur de réception d'émissions radiophoniques mais peut être fabriqué à bas prix.

Il comprend, de façon en soi connue, un circuit, notamment sous forme intégrée, à sortie de silencieux ou "muting" sur laquelle apparaît un signal d'un premier niveau quand aucune émission n'est reçue et un signal d'un second niveau quand une émission est reçue. Il est caractérisé en ce qu'il comporte un indicateur lumineux sensible au signal de sortie de silencieux et formant indicateur de réception ou d'accord.

Il est vrai qu'on connait déjà des montages dans lesquels les circuits d'accord et de silencieux sont combinés. Mais dans ces montages connus c'est le signal de circuit indicateur d'accord qui est utilisé pour engendrer le signal de silencieux alors que le montage de l'invention est inverse et peut être d'une très grande simplicité.

On peut prévoir un simple comparateur dont la première entrée reçoit le signal de silencieux et la seconde entrée un signal de référence, une diode électroluminescente étant alors en série avec la sortie de ce comparateur.

Ainsi le signal de silencieux remplit une double fonction : la première est sa fonction usuelle qui est d'éliminer le souffle quand

2

on recherche une station et la seconde est celle de l'invention qui est l'indication de réception d'une émission par un signal lumineux.

D'autres caractéristiques de l'invention apparaîtront avec la description de certains de ses modes de réalisation, celle-ci étant effectuée en se référant aux dessins ci-annexés sur lesquels :

la figure 1 est un schéma d'une partie d'un récepteur selon l'invention, et

la figure 2 est une variante de la figure 1.

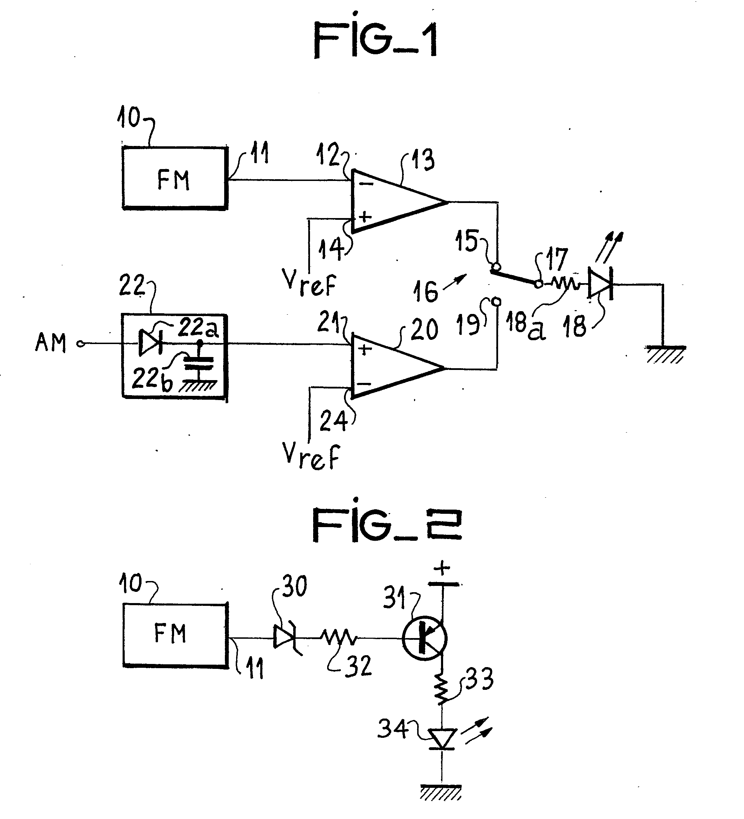

Le récepteur (figure 1) comprend une partie à modulation de fréquence FM dont le démodulateur est sous forme d'un circuit intégré 10 tel que celui celui de référence TVA 1200, CA 30-89, CA 31-89 ou HA 11-225, avec une sortie 11 de silencieux ou muting. Sur cette sortie 11 apparaît un signal continu, dont le niveau est fonction directe de l'écart entre la fréquence correspondant au réglage du récepteur et la fréquence d'une station émettrice. Ce niveau est donc d'autant plus élevé que cet écart est grand. Ce signal de silencieux est utilisé par des moyens, non représentés, connus en eux-mêmes, pour supprimer le souffle, gênant pour l'auditeur, quand aucune émission n'est reçue, notamment lorsque l'utilisateur recherche une station.

Selon l'invention, ce signal de silencieux sur la sortie 11 est en outre appliqué sur une entrée 12 (-) d'un comparateur 13 sur l'autre entrée 14 (+) duquel est appliqué un signal de référence $V_{ref}$.

La sortie du comparateur 13 est reliée à une première borne d'extrémité 15 d'un commutateur 16 à deux positions dont la borne centrale 17 est reliée à la masse par l'intermédiaire d'une résistance $18_a$ de limitation de courant et d'une diode électroluminescente 18. La seconde borne d'extrémité 19 du commutateur 16 est reliée à la sortie d'un second comparateur 20 dont la première entrée 21 (+) reçoit le signal de sortie d'un redresseur 22 à diode $22_a$ et condensateur $22_b$ fournissant un signal d'un premier niveau, égal à "1" par convention, quand une émission en modulation d'amplitude AM est reçue et un signal d'un second niveau, égal par convention à "0", dans le cas contraire. Sur la seconde entrée 24 (-) du comparateur 20 est appliqué un signal de référence $V'_{ref}$.

Le signal à l'entrée du redresseur 22 est le signal de sortie de la détection AM.

La position du commutateur 16 dépend du mode de réception : en modulation de fréquence la sortie du comparateur 13 est reliée à la masse par l'intermédiaire de la diode électroluminescente 18, la sortie du comparateur 20 étant alors en l'air. En modulation d'amplitude la sortie du comparateur 20 est reliée à la masse à travers la diode 18.

En cas de réception en modulation de fréquence, si aucune émission n'est détectée ou si le niveau du signal reçu est inférieur à un seuil prédéterminé le signal de sortie de silencieux est supérieur au niveau du signal sur l'entrée 14. Le comparateur 13 ne débite alors aucun courant et la diode 18 reste éteinte. Ledit seuil prédéterminé est fonction de la tension $V_{ref}$. Si une émission est détectée, le signal sur la sortie 11 est à un faible niveau, inférieur à celui du signal $V_{ref}$. Le comparateur 13 débite alors un courant permettant d'allumer la diode électroluminescente 18.

Si le récepteur fonctionne en modulation d'amplitude, une émission reçue se traduit par un signal sur l'entrée 21 du comparateur 20 dont le niveau est supérieur à celui du signal $V'_{ref}$ appliqué sur son entrée 24; le comparateur 20 débite alors un courant dans la diode 18 par l'intermédiaire du commutateur 16 se trouvant dans la position correspondante, qui est l'inverse de celle représentée sur la figure 1. Si aucune émission n'est détectée, le signal de sortie du redresseur 22 est à un niveau inférieur à celui du signal $V'_{ref}$ et le comparateur 20 ne débite aucun courant; la diode 18 reste alors éteinte.

Pour réaliser les deux comparateurs 13 et 20 on fait appel, par exemple, à un double amplificateur opérationnel tel que celui de référence LM 358 P.

Dans l'exemple de la figure 2 la sortie 11 de silencieux du démodulateur FM est reliée à l'anode d'une diode Zener 30 dont la cathode est reliée à la base d'un transistor 31 par l'intermédiaire d'une résistance 32. L'émetteur du transistor 31 est connecté au pôle positif (+) d'une source de tension tandis que son collecteur est relié à la masse par l'intermédiaire d'une résistance 33 et d'une diode électroluminescente 34 en série.

Quand le réglage est éloigné de l'accord, le niveau du signal sur la sortie 11 empêche la conduction du transistor 31. Ce dernier conduit quand le niveau du signal de silencieux est suffisamment bas, c'est-à-dire quand la fréquence de réglage est pratiquement égale à celle de l'accord. Dans ce cas la diode 34 émet un rayonnement lumineux.

Le seuil du signal de silencieux à partir duquel la diode 34 s'allume est fonction de la tension Zener de la diode 30;

En variante encore, à la place d'un comparateur ou d'un transistor on fait appel à une bascule de Schmidt ou à une porte logique.

## REVENDICATIONS

1. Récepteur radiophonique comportant un circuit (10), notamment sous forme intégrée, à sortie de silencieux (11) délivrant un signal d'une première valeur quand une émission est détectée et d'une seconde valeur en l'absence d'émission détectée, caractérisé en ce qu'il comporte un indicateur lumineux (18, 34) sensible au signal délivré par ladite sortie (11) de silencieux et qui forme ainsi un indicateur de réception ou d'accord.

2. Récepteur selon la revendication 1, caractérisé en ce qu'il comporte un comparateur (13) dont une première entrée est reliée à la sortie de silencieux et sur la seconde entrée (14) duquel est appliqué un signal de référence ($V_{ref}$) et dont la sortie fournit le courant d'alimentation de l'indicateur lumineux (18).

3. Récepteur selon la revendication 1 ou 2, caractérisé en ce que l'indicateur lumineux est une diode électroluminescente.

4. Récepteur selon l'une quelconque des revendications précédentes, caractérisé en ce que ledit circuit (10) qui est sous forme intégrée est un démodulateur FM.

5. Récepteur selon la revendication 4, caractérisé en ce qu'il comprend un redresseur (22) pour les signaux reçus d'une partie en modulation d'amplitude AM et un commutateur (16) à deux positions pour connecter l'indicateur lumineux (18) de façon qu'il soit sensible au signal de sortie du redresseur lors de la réception d'émissions en modulation d'amplitude.

6. Récepteur selon la revendication 5, caractérisé en ce qu'il comporte un comparateur (20) dont une première entrée (21) est reliée à la sortie du redresseur (22) et sur la seconde entrée (24) duquel est appliqué un signal de référence ($V'_{ref}$), la sortie de ce comparateur débitant dans l'indicateur lumineux (18) par l'intermédiaire du commutateur (16).

7. Récepteur selon les revendications 2 et 6, caractérisé en ce qu'il comprend un amplificateur opérationnel double monté pour former les deux comparateurs (13, 20).

8. Récepteur selon la revendication 1, caractérisé en ce que l'indicateur lumineux (34) est relié à une source par l'intermédiaire d'un interrupteur (31) dont la conduction est fonction du niveau du signal de silencieux.

9. Récepteur selon la revendication 8, caractérisé en ce que l'interrupteur étant un transistor, la base de ce dernier est reliée à la sortie du silencieux par l'intermédiaire d'un élément à seuil tel qu'une diode Zener (30).

# FIG_1

10
FM
11  12  13
−
+
14
$V_{ref}$

22
22a
AM
22b
21  20  19  18a  18
+
−
24
$V_{ref}$

15  16  17

# FIG_2

10
FM
11  30  32  31
+
33
34

# 0062590

## RAPPORT DE RECHERCHE EUROPEENNE

Office européen des brevets

Numero de la demande

EP 82 40 0630

## DOCUMENTS CONSIDERES COMME PERTINENTS

| Categorie | Citation du document avec indication, en cas de besoin, des parties pertinentes | Revendication concernée | CLASSEMENT DE LA DEMANDE (Int. Cl. ³) |
|---|---|---|---|
| X | GRUNDIG TECHNISCHE INFORMATIONEN, vol. 24, no. 6, juin 1977, Furth (DE) E. SCHWARZ: "HiFi-Receiver R 35, HiFi nach DIN 45 500", pages 301-305. <br><br> * figures 4,12; page 301, colonne 1, ligne 28 - page 302, colonne 1, ligne 52; page 303, colonne 3, ligne 7 - page 304, colonne 3, ligne 33 * <br><br> -- | 1-5,7 | H 03 J 3/14 |
| X | PROCEEDINGS OF THE INSTITUTION OF RADIO & ELECTRONICS ENGINEERS AUSTRALIA, vol. 36, no. 9, septembre 1975, J.P. PIK: "High fidelity (Synchrodyne) AM broadcast tuner", pages 300-309. <br><br> * schéma page 307; figures 8-9; page 308, colonne 1, ligne 12 - page 309, colonne 1, ligne 8 * <br><br> -- | 1-3,6-7. | |
| X | WIRELESS WORLD, vol. 80, no. 1400, avril 1974 Sussex (GB) J.A. SKINGLEY et al.: "Novel stereo f.m. tuner, pages 58-62. <br><br> * figures 1,4,6; résumé page 58, lignes 1-8; page 60, colonne 3, ligne 28 - page 61, colonne 2, ligne 19 * | 1,3,4,8 | |

DOMAINES TECHNIQUES RECHERCHES (Int. Cl. ³)

G 01 R
H 03 G
H 03 J

Le present rapport de recherche a été établi pour toutes les revendications

| Lieu de la recherche | Date d'achevement de la recherche | Examinateur |
|---|---|---|
| LA HAYE | 08-07-1982 | RATAJSKI |

**Office européen des brevets**

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendica-tion concernée |
|---|---|---|
| A | FR - A - 2 339 288 (OPTALIX)<br><br>* figures 2-4; page 3, ligne 1 - page 4, ligne 21 *<br><br>-- | 1,3,6, 8,9 |
| A | US - A - 3 987 401 (C.R. IRVING)<br><br>* figures 3,5; colonne 4, ligne 43 - colonne 5, ligne 19; colonne 5, ligne 66 - colonne 7, ligne 34 *<br><br>------ | 1,3,5, 8 |

**CLASSEMENT DE LA DEMANDE (Int. Cl.³)**

**DOMAINES TECHNIQUES RECHERCHES (Int. Cl.³)**

OEB Form 1503.2 06.78